# EUROPEAN PATENT APPLICATION

(11) **EP 1 482 373 A1**
(43) Date of publication of application: **01.12.2004**
(21) Application number: 03253419.0
(22) Date of filing: 30.05.2003
(51) Int. Cl.: G03F 9/00, G03F 7/20

(54) **Lithographic apparatus and device manufacturing method**

(71) Applicant: ASML Netherlands B.V., 5504 DR Veldhoven (NL)
(72) Inventor: The designation of the inventor has not yet been filed
(74) Representative: Leeming, John Gerard

(57) **Abstract**

Lithographic apparatus in which alignment marks on the substrate are inspected during the exposure of the substrate to optimize the exposure conditions.

## Description

The present invention relates to a lithographic projection apparatus comprising:
- a radiation system for supplying a projection beam of radiation;
- programmable patterning means for patterning the projection beam according to a desired pattern;
- a substrate table for holding a substrate; and
- a projection system for projecting the patterned beam onto a target portion of the substrate.

Lithographic projection apparatus are used in the manufacture of integrated circuits (ICs), flat panel displays and other devices involving fine structures. The programmable patterning means generates a pattern corresponding to an individual layer of, for example, the IC, and this pattern is imaged onto a target portion (e.g. comprising part of, one or several dies) on a substrate (e.g. silicon wafer or glass plate) that has been coated with a layer of radiation-sensitive material (resist).

Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. These transfer procedures result in a patterned layer of resist on the substrate. One or more pattern steps, such as deposition, etching, ion-implantation (doping), metallization, oxidation, chemo-mechanical polishing, etc., follow, each of which is intended to finish, create or modify a layer of the device. If several layers are required, then the whole procedure, or a variant thereof, is repeated for each new layer. Eventually, an array of devices will be present on the substrate (wafer). These devices are then separated from one another by a technique such as dicing or sawing, whence the individual devices can be mounted on a carrier, connected to pins, etc.. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

In order to manufacture devices using lithographic techniques, it is typically necessary to form the device from multiple layers. When producing such a device from multiple layers, it is necessary to ensure that, as each layer is created, it is aligned with the previous layers. It has therefore been known to provide alignment marks on a substrate. Before each layer is exposed on the substrate, it is transported to an alignment measuring centre, where the alignment marks are located, allowing a precise determination of the position of the substrate relative to the alignment sensors. By moving the substrate in a controlled manner to the exposure position, a positional correction can be applied to accurately produce the subsequent layer in the correct position on the substrate. Such a system can be used to ensure that the overlay errors are small in comparison to the critical feature size.

However, as the critical feature size continues to diminish, further improvements in the overlay accuracy are required. Furthermore, as the alignment requirements increase, the time taken to locate and inspect the alignment marks increases, reducing the throughput of the apparatus.

It is an object of the present invention to provide a method and apparatus in which the overlay accuracy can be improved without significant loss of throughput of the apparatus.

This and other objects are achieved according to the invention in a lithographic apparatus as specified in the opening paragraph, characterized in that the apparatus further comprises a detector for inspecting alignment marks on a portion of the substrate while the substrate is in a position for the projection system to project the patterned beam onto the substrate; and
a controller for adjusting at least one of: the position of the pattern projected onto the substrate relative to the substrate; the magnification of the pattern projected onto the substrate; and the best focus image plane in response to information from the detector.

Such apparatus is beneficial since the overlap accuracy for each portion of the substrate can be improved. Furthermore, since the alignment marks can be detected while the substrate is in the exposure position, errors are not introduced in moving the substrate from an alignment measuring position to the exposure position. Beneficially, since the alignment marks can be inspected whilst the substrate is in the exposure position, the overlay can take into account not only defects that are introduced into the substrate during the previous processing step but also it can take account of changes that occur during the exposure of that layer. For example, this system can compensate for expansion/contraction of the substrate during the exposure caused by heating of the substrate by the radiation used to expose each layer. Consequently, the overlay accuracy of each part of the substrate is improved. Furthermore, since the substrate does not need to be transported to a separate alignment measuring center, the processing time of the substrate is not significantly increased.

Preferably, by inspecting the alignment marks, on a portion of the substrate, the detector can determine the position and/or orientation of that portion of the substrate and/or the amount that that portion of the substrate has expanded/contracted relative to a reference state of the substrate. This information can be used to adjust the position of the pattern projected onto the substrate, the magnification of the pattern projected onto the substrate and the best focus image plane.

The position of the detector relative to the projection system may be substantially fixed and known or a position sensor may be provided for monitoring the position of the detector relative to the projection system. Consequently, knowledge of the position of a portion of the substrate relative to the detector may be readily and accurately converted to knowledge of the position of the portion of the substrate relative to the projection system.

In a preferred embodiment, the substrate is moved relative to the projection system and the detector between consecutive exposures and the detector is arranged so that the portions of the substrate in which the detector inspects the alignment marks subsequently become the target portions of the substrate which are exposed. The distance the substrate has to move relative to the detector and the projection system is known from the relative positions of the detector and the projection system. Consequently, the detector can inspect the alignment marks on a given portion of the substrate shortly before this portion of the substrate is exposed; and the exposure conditions can be adjusted accordingly to optimize the overlay accuracy when that portion of the substrate is being exposed.

Conveniently, the substrate may move at a substantially constant velocity relative to the projection system and the detector over the course of a plurality of exposures. This reduces the requirement for the substrate to be repeatedly accelerated relative to the projection system and the detector, thus reducing the forces that must be applied. It is also, therefore, possible to adjust the position of a pattern projected onto the substrate in a direction parallel to the movement of the substrate relative to the projection system and detector by altering the timing of the exposures.

The position of the pattern projected onto the substrate may additionally or alternatively be adjusted by physically moving the projection system, the programmable patterning means, the substrate or a combination of these and/or by shifting the position of the pattern produced on the programmable patterning means.

The invention may also be applied to apparatus in which the programmable patterning means is made up of a plurality of individual programmable patterning areas that are set apart from one another. In this case, the controller can independently adjust, for one or more of the patterns produced by the programmable patterning areas, the position of the pattern projected onto the substrate, the magnification of the pattern and/or the best focus image plane. This allows for compensation of any movement between the individual programmable patterning areas in the programmable patterning means and also allows for compensation of a variance between the different areas of the substrate onto which the patterns from each of the programmable patterning areas are projected.

In order to facilitate this, the detector may be able to simultaneously inspect alignment marks at a plurality of locations on the substrate, each corresponding to an area on the substrate that will be simultaneously exposed by the plurality of programmable patterning areas.

According to a further aspect of the invention there is provided:
a device manufacturing method comprising the steps of:
   - providing a substrate;
   - providing a projection beam of radiation using a radiation system;
   - using programmable patterning means to pattern the projection beam; and
   - projecting the patterned beam of radiation onto a target portion of the substrate; characterized by inspecting alignment marks on a portion of the substrate while the substrate is in a position for the projection system to project the patterned beam onto the substrate; and
adjusting at least one of the position of the patterned projected onto the substrate relative to the substrate, the magnification of the pattern projected onto the substrate and the best focus image plane in response to information from inspecting the alignment marks.

The term "programmable patterning means" as here employed should be broadly interpreted as referring to any means that can be used to endow an incoming radiation beam with a patterned cross-section, so that a desired pattern can be created in a target portion of the substrate; the terms "light valve" and "Spatial Light Modulator" (SLM) can also be used in this context. Examples of such patterning means include:
- A programmable mirror array. This may comprise a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate spatial filter, the said undiffracted light can be filtered out of the reflected beam, leaving only the diffracted light to reach the substrate; in this manner, the beam becomes patterned according to the addressing pattern of the matrix-addressable surface. An array of grating light valves (GLV) can also be used in a corresponding manner. Each GLV is comprised of a plurality of reflective ribbons that can be deformed relative to one another to form a grating that reflects incident light as diffracted light. A further alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the programmable patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference.
- A programmable LCD array. An example of such a construction is given in United States Patent US 5,229,872, which is incorporated herein by reference.

It should be appreciated that where pre-biasing of features, optical proximity correction features, phase variation techniques and multiple exposure techniques are used, the pattern "displayed" on the programmable patterning means may differ substantially from the pattern eventually transferred to a layer of or on the substrate.

For the sake of simplicity, the projection system may be referred to as the "lens"; however, this term should be broadly interpreted as encompassing various types of projection system, including refractive optics, reflective optics, catadioptric systems and micro lens arrays, for example. It is to be understood that the term "projection system" as used in this application simply refers to any system for transferring the patterned beam from the programmable patterning means to the substrate. The radiation system may also include components operating according to any of these design types for directing, shaping or controlling the projection beam of radiation, and such components may also be referred to below, collectively or singularly, as a "lens". It has been proposed to fill a space between the final element of the projection system and the substrate with a liquid that has a refractive index of greater than one. This enables imaging of smaller features because the exposure radiation will have a shorter wavelength in liquid. The present invention may be used with apparatus of this type. Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, thin film transistor liquid crystal displays, printed circuit boards (PCBs), etc.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, e.g. having a wavelength in the range 5-20 nm), as well as particle beams, such as ion beams or electron beams.

Exemplary embodiments of the invention will now be described, by way of example only, with reference to the accompanying schematic drawings, in which:
Figure 1 depicts a lithographic projection apparatus according to an embodiment of the invention;
Figures 2a, 2b and 2c depict a substrate at three time instances as a layer on the substrate is being exposed;
Figure 3 depicts an arrangement of an exposure unit used in this apparatus;
Figure 4 depicts a part of an exposure unit as shown in Figure 3; and
Figure 5 depicts the exposure field that may be produced by an exposure system as shown in Figure 3.

In the Figures, corresponding reference symbols indicate corresponding parts.

### Embodiment 1

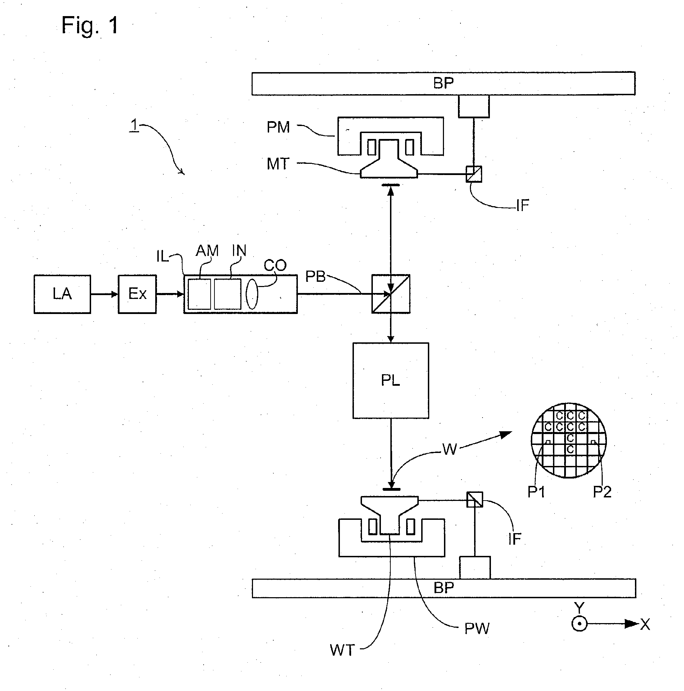

Figure 1 schematically depicts a lithographic projection apparatus according to a particular embodiment of the invention. The apparatus comprises:
- a radiation system Ex, IL, for supplying a projection beam PB of radiation (*e.g.* UV radiation), which in this particular case also comprises a radiation source LA;
- a programmable patterning means PPM (e.g. a programmable mirror array) for applying a pattern to the projection beam; in general the position of the programmable patterning means will be fixed relative to item PL; however it may instead be connected to a positioning means for accurately positioning it with respect to item PL;
- an object table (substrate table) WT provided with a substrate holder for holding a substrate W (*e.g.* a resist-coated silicon wafer), and connected to positioning means for accurately positioning the substrate with respect to item PL;
- a projection system ("lens") PL (*e.g.* a quartz and/or CaF₂ lens system or a catadioptric system comprising lens elements made from such materials, or a mirror system) for projecting the patterned beam onto a target portion C (e.g. comprising one or more dies) of the substrate W; the projection system may project an image of the programmable patterning means onto the substrate; alternatively, the projection system may project images of secondary sources for which the elements of the programmable patterning means act as shutters; the projection system may also comprise a micro lens array (known as an MLA), *e.g.* to form the secondary sources and to project microspots onto the substrate.

As here depicted, the apparatus is of a reflective type *(i.e.* has a reflective programmable patterning means). However, in general, it may also be of a transmissive type, for example (*i.e.* with a transmissive programmable patterning means).

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the programmable patterning means PPM has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the programmable patterning means PPM. Having been reflected by the programmable patterning means PPM, the beam PB passes through the projection system PL, which focuses the beam PB onto a target portion C of the substrate W. With the aid of the positioning means (and interferometric measuring means IF), the substrate table WT can be moved accurately, *e.g.* so as to position different target portions C in the path of the beam PB. Where used, the positioning means for the programmable patterning means can be used to accurately correct the position of the programmable patterning means PPM with respect to the path of the beam PB, *e.g.* during a scan. In general, movement of the object table WT is realized with the aid of a long-stroke module (course positioning) and a short-stroke module (fine positioning), which are not explicitly depicted in Figure 1. A similar system may also be used to position the programmable patterning means. It will be appreciated that the projection beam may alternatively/additionally be moveable while the object table and/or the programmable patterning means may have a fixed position to provide the required relative movement.

Although the lithography apparatus according to the invention is herein described as being for exposing a resist on a substrate, it will be appreciated that the invention is not limited to this use and the apparatus may be used to project a patterned projection beam for use in resistless lithography.

The depicted apparatus can be used in four preferred modes:
1. Step mode: the entire pattern on the programmable patterning means is projected in one go (i.e. a single "flash") onto a target portion C. The substrate table WT is then moved in the x and/or y directions to a different position for a different target portion C to be irradiated by the beam PB.
2. Scan mode: essentially the same as step mode, except that a given target portion C is not exposed in a single "flash". Instead, the programmable patterning means is movable in a given direction (the so-called "scan direction", e.g. the y direction) with a speed v, so that the projection beam PB is caused to scan over the programmable patterning means; concurrently, the substrate table WT is simultaneously moved in the same or opposite direction at a speed V = Mv, in which M is the magnification of the lens PL. In this manner, a relatively large target portion C can be exposed, without having to compromise on resolution.
3. Pulse mode: the programmable patterning means is kept essentially stationary and the entire pattern is projected onto a target portion C of the substrate using a pulsed radiation source. The substrate table WT is moved with an essentially constant speed such that the projection beam PB is caused to scan a line across the substrate W. The pattern on the programmable patterning means is updated as required between pulses of the radiation system and the pulses are timed such that successive target portions C are exposed at the required locations on the substrate. Consequently, the projection beam can scan across the substrate W to expose the complete pattern for a strip of the substrate. The process is repeated until the complete substrate has been exposed line by line.
4. Continuous scan mode: essentially the same as pulse mode except that a substantially constant radiation source is used and the pattern on the programmable patterning means is updated as the projection beam scans across the substrate and exposes it.

Combinations and/or variations on the above described modes of use or entirely different modes of use may also be employed.

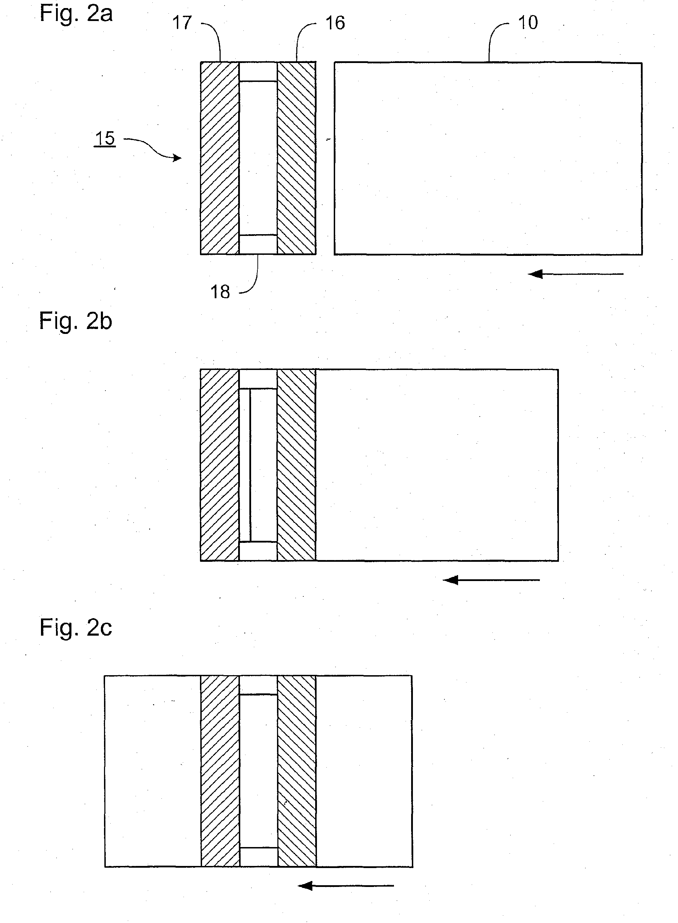

Figures 2a, 2b and 2c illustrate an apparatus according to the present invention that operates in pulse mode (described above). An exposure and alignment module 17 is provided in a fixed location and a substrate 10 is scanned beneath it. Figure 2a depicts the situation immediately before the substrate reaches the exposure and alignment module 15; Figure 2b depicts the situation as the substrate begins to scan beneath the exposure and alignment module; and Figure 2c depicts the situation as the substrate continues to scan beneath the exposure and alignment module 15.

The exposure and alignment module 15 is comprised of a detector unit 16 and an exposure unit 17. The detector unit 16 and exposure unit 17 are connected by means of a reference frame 18 that ensures that the relative position of the exposure unit 17 to the detector unit 16 is fixed. The reference frame 18 may be formed from a material having very low thermal expansion to ensure that the relative positions are stable. The relative position can then be accurately determined by prior calibration. As the substrate is scanned beneath the exposure and alignment module, the detector unit 16 inspects alignment marks on the substrate 10. The information from inspecting the alignment marks is used to accurately determine the position of the substrate in the scan direction, in the transverse direction (i.e. within the plane of the substrate and perpendicular to the scan direction) and perpendicular to the substrate. Furthermore, the alignment marks may be used to ascertain the orientation of the substrate in all three degrees of rotational freedom. The detector unit 16 also inspects the alignment marks to determine the extent of any thermal expansion/contraction of the substrate.

As the substrate 10 scans beneath the exposure and alignment unit 15, each part of the substrate passes first under the detector unit 16 and then under the exposure unit 17. Consequently, the linear position, orientation and expansion information, determined by the detector unit 16, for each portion of the substrate 10 can be transferred to the exposure unit 17 so that the exposure conditions for that portion of the substrate can be optimized when it is exposed as it passes underneath the exposure unit 17. In particular, the position of the pattern projected onto the portion of the substrate can be adjusted for errors in the position of the portion of the substrate in the scan and transverse directions; the best focus image plane can be adjusted for errors in the position of that portion of the substrate in the direction perpendicular to the plane of the substrate; and magnification corrections can be made to correct for any thermal expansion/contraction of that portion of the substrate.

Alignment marks on each portion of the substrate are inspected, allowing continuous corrections to be made. Consequently, overlay errors can be reduced even when there is local deformation of the substrate. Furthermore, the time difference between inspecting the alignment marks and the substrate and exposing the pattern on that part of the substrate is only limited by the separation of the detector unit 16 and the exposure unit 17 and the scanning speed of the substrate. This is in contrast to presently known apparatus in which the substrate is first scanned in its entirety for alignment marks and then scanned in its entirety to expose the pattern. This results in a large time difference between a given portion of the substrate being inspected for alignment marks and that portion being exposed. During this time, additional deformations may be introduced which will result in overlay errors. For example, as the substrate is exposed, the radiation projected onto the substrate increases its temperature. This temperature increase results in a thermal expansion of the substrate. In known systems, this thermal expansion during exposure cannot be accounted for by inspecting alignment marks in a process that is separate to the exposure. In the present invention, however, this expansion is accounted for since the alignment marks are inspected as the exposure takes place. It is especially important for flat-panel display lithography which may be used to image soda-lime glass plates up to two metres long. For such a plate, the expansion would be approximately 8mm per 1°C temperature change. Therefore, to provide a required overlay accuracy of 0.35mm without inspecting alignment marks during exposure, the temperature of the substrate would need to be controlled to ± 0.01°C over the entire plate. This would require complicated thermal control.

Furthermore, since the present invention does not require a separate process for inspecting the alignment marks on the substrate, the processing time for each substrate is greatly reduced.

The alignment marks on the substrate may be: alignment gratings parallel to both the scan direction and the transverse direction; chevron alignment marks as used; or image recognition via TV imaging. In each case, known detection optic systems, appropriate for the alignment marks used, are provided in the detector unit 16.

The position of the pattern that is projected onto the substrate may be moved by several means. Firstly, the position of the substrate 10 may be corrected as it scans beneath the exposure and alignment unit 15. For instance, the substrate table may be mounted on a long-stroke module that provides the scanning motion; with a short-stroke module mounted between the long-stroke module and the substrate table to provide the corrective movement. Alternatively, the exposure and alignment unit 15 or, at least, the exposure unit 17 (or a part thereof) may be mounted on an actuator to provide corrective movements in order to project the pattern onto the correct portion of the substrate. A further option would be to move the pattern formed on the programmable patterning means electronically (namely to adjust the data provided to the programmable patterning means such that the pattern appears shifted on the programmable patterning means). The position of the pattern projected onto the substrate in a direction parallel to the scanning direction can also be adjusted by controlling the timing of the exposure of the pattern as the substrate is scanned beneath the exposure unit 17. Of course, a combination of the above-described techniques may also be used.

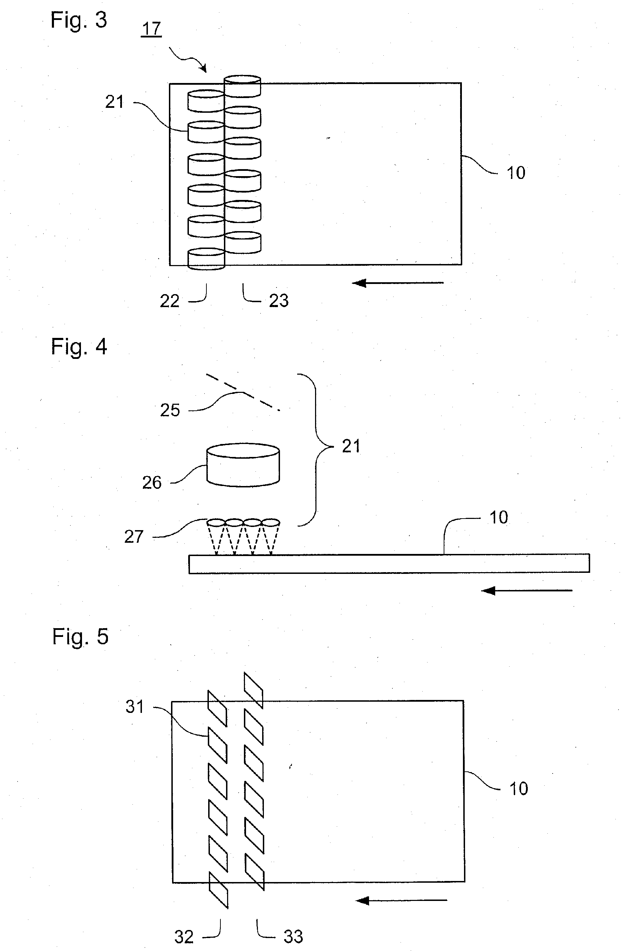

Figure 3 depicts a detail of an exposure unit 17 that may be used with the present invention. The exposure unit is comprised of a plurality of light engines 21 that are each capable of producing a patterned beam of radiation and projecting it onto the substrate 10. As shown in Figure 3, the light engines 21 are arranged in two arrays 22, 23 perpendicular to the scan direction of the substrate. Figure 4 shows a detail of a light engine 21. The light engine is comprised of a programmable patterning means 25, projection optics 26 and a micro-lens array 27. Two or more light engines 21 may share a common radiation source or each may be provided with an independent radiation source. It will also be appreciated that although, as shown, the light engine uses a micro-lens array, the programmable patterning means 25 may be wholly imaged onto the substrate 10.

As shown in Figure 5, the arrays 22, 23 of light engines 21 produce corresponding arrays 32, 33 of pattern images 31 on the substrate 10. In each array 22, 23 of light engines 21, space is provided between the light engines. This space may be used to provide ancillary services for the light engines, such as cooling or to provide space for radiation sources. Consequently, there are gaps in the arrays 32, 33 of patterned images 31 projected onto the substrate. The arrays 22, 23 of light engines are arranged such that the second array 32 of patterned images 31 projected onto the substrate by the second array of light engines 22 coincide with the gaps in the first array 33 of patterned images projected onto the substrate by the first array 23 of light engines after the substrate has moved a given distance. Consequently, a complete strip of the substrate across the transverse direction can be exposed notwithstanding the gap between the light engines 21. As shown in Figures 3 and 5, there are two arrays of light engines 21. It will be appreciated, however, that additional arrays can be provided in the exposure unit 17, for example to allow for larger gaps between the light engines 21 or to allow each part of the substrate to receive more than one exposure within a single scan.

In a preferred embodiment, each of the adjustments that are made to the pattern projected onto the substrate in response to information from the detector unit 16 can be made independently by each of the light engines. This may be effected by providing individual actuators to control the position of each of the light engines 21, by providing magnification control and best focus image plane control in the projection optics 26 of each of the light engines 21 and/or by providing separate data control for each of the light engines so that electronic corrections can be applied independently. By this means it is possible to compensate for local distortions and deformations across the substrate. It may, however, be desirable to also provide global compensation means (i.e. compensation means that affect the pattern produced by all of the light engines) to compensate for, for example, positional errors of the substrate as a whole.

Where the light engines are not mounted on separate actuators, the micro-lens arrays of all of the light engines may be mounted on a single reference frame that, preferably, has a very low thermal expansion. However, if required, the position of each micro-lens array relative to the reference frame may be adjustable. Similarly, the programmable patterning means of all of the light engines may be mounted on a separate reference frame and the position of each relative to the reference frame may be adjustable. Consequently, the relative positions of the patterns produced by the light engines can be measured and calibrated.

The magnification of each light engine can be adjusted by changing the position of the programmable patterning means to compensate for any expansion/contraction of the substrate. As before, this may be performed independently for each light engine and/or globally for all light engines (for example, by adjusting the position of the reference frame on which all of the programmable patterning means are mounted). Preferably, the magnification control range is ± 15 ppm.

In a variant of the above-described embodiment, the projection unit 16 and the exposure unit 17 may not be rigidly connected to one another or may be connected by a frame that is subject to thermal expansion/contraction. In this case, a position sensor must be provided to monitor the position of the exposure unit 17 relative to the detection unit 16. Thus the relative position remains known, even if it is not fixed.

It is further to be appreciated that although the invention has been described above in relation to an apparatus that uses the pulse mode (described above), in which the substrate is moved at an essentially constant speed and the exposures are pulsed, it will be appreciated that the invention may equally be applied to apparatus that operates in a stepped mode (described above) and apparatus that operates in a scan mode (described above). Furthermore, although the invention refers to the use of a programmable patterning means for patterning the radiation means, it will be appreciated that the invention may be equally be applied to apparatus using a conventional fixed mask to pattern the projection beam. In this case, it may be used, for example, with an apparatus operating in scan mode: the detector could be located between the mask and the substrate and arranged to precede the patterned projection beam as it scans across the substrate. Finally, although the invention has been described in terms of the substrate being moved below the exposure and alignment unit, it will be readily appreciated that the absolute positions described are not essential to the invention nor is it essential that a given part of the apparatus is fixed: it is only necessary that the substrate move relative to the exposure and alignment unit.

Whilst specific embodiments of the invention have been described above, it will be appreciated that the invention may be practiced otherwise than as described. The description is not intended to limit the invention.

## Claims

1. A lithographic projection apparatus comprising:
- a radiation system for providing a projection beam of radiation;
- programmable patterning means for patterning the projection beam according to a desired pattern;
- a substrate table for holding a substrate; and
- a projection system for projecting the patterned beam onto a target portion of the substrate;
**characterized in that** the apparatus further comprises a detector for inspecting alignment marks on a portion of the substrate while the substrate is in a position for the projection system to project the patterned beam onto the substrate; and
a controller for adjusting at least one of: the position of the pattern projected onto the substrate relative to the substrate; the magnification of the pattern projected onto the substrate; and the best focus image plane in response to information from the detector.

2. A lithographic projection apparatus according to claim 1, wherein the detector determines, from inspecting the alignment marks on a portion of the substrate, at least one of the position and/or orientation of said portion of the substrate relative to the detector in one or more directions and the expansion/contraction of said portion of the substrate relative to a standard scale.

3. A lithographic projection apparatus according to claim 1 or 2, wherein the position of the detector relative to the projection system is substantially fixed and is known.

4. A lithographic projection apparatus according to claim 1, 2 or 3, further comprising a position sensor for monitoring the position of the detector relative to the projection system.

5. A lithographic projection apparatus according to any preceding claims, further comprising positioning means for moving the substrate relative to the projection system and the detector to consecutively expose different areas of the substrate;
wherein the detector is arranged to inspect the alignment marks of a given area of the substrate before that area is exposed.

6. A lithographic projection apparatus according to claim 5, wherein the apparatus is configured to move the substrate at a substantially constant velocity relative to the projection system and the detector throughout a sequence of a plurality of exposures.

7. A lithographic projection apparatus according to any one of the preceding claims, wherein the position of a pattern projected onto the substrate is adjusted by at least one of physically moving the projection system and/or the programmable patterning means and/or the substrate, adjusting the timing of the exposure and electronically adjusting the position of the pattern on the programmable patterning means.

8. A lithographic projection apparatus according to any one of the preceding claims, wherein the programmable patterning means comprises a plurality of programmable patterning areas set apart from one another; and
the controller can independently adjust at least one of the position of the pattern projected onto the substrate, the magnification of the pattern projected onto the substrate and the best focus image plane corresponding to at least one of the programmable patterning areas.

9. A lithographic projection apparatus according to any one of the preceding claims, wherein the detector is arranged to simultaneously inspect alignment marks on a plurality of portions of the substrate that are set apart from one another.

10. A device manufacturing method comprising the steps of:
- providing a substrate;
- providing a projection beam of radiation using a radiation system;
- using programmable patterning means to pattern the projection beam; and
- projecting the patterned beam of radiation onto a target portion of the substrate;
**characterized by** inspecting alignment marks on a portion of the substrate while the substrate is in a position for the projection system to project the patterned beam onto the substrate; and
adjusting at least one of the position of the patterned projected onto the substrate relative to the substrate, the magnification of the pattern projected onto the substrate and the best focus image plane in response to information from inspecting the alignment marks.
